# EUROPEAN PATENT APPLICATION

(11) **EP 4 760 751 A1**
(43) Date of publication of application: **17.06.2026**
(21) Application number: 23810274.3
(22) Date of filing: 11.11.2023
(51) Int. Cl.: H01B 1/16, H01B 1/22, H01B 1/00, H01B 13/00, H10F 77/20, H10F 99/00, C03C 8/24

(54) **HIGH-PERFORMANCE CONDUCTIVE SILVER-ALUMINUM PASTE AND PREPARATION METHOD THEREFOR, ELECTRODE AND N-TYPE TOPCON BATTERY**

(30) Priority: 08.08.2023 CN 202310986326
(71) Applicant: Shanghai Silver Paste Sci. & Tech. Co., Ltd., Shanghai 201613 (CN)
(72) Inventor: SHU, Mingfei, Shanghai 201613 (CN); CHEN, Xiaolong, Shanghai 201613 (CN); LIU, Jie, Shanghai 201613 (CN); WANG, Liang, Shanghai 201613 (CN)
(74) Representative: Zaboliene, Reda
(86) International application number: PCT/CN2023/131140
(87) International publication number: WO 2025/030701

(57) **Abstract**

The present invention discloses a high-performance conductive silver aluminum paste, the conductive silver aluminum paste comprises silver powder, aluminum powder, glass powder, silver aluminum paste additive, and organic carrier; when defining the total weight of the conductive silver aluminum paste as 100%, the weight percentage contents of the components are: silver powder 80.0%-88.0%, aluminum powder 0.5%-2.0%; glass powder 2.5%-6.0%; silver aluminum paste additive 0.1%-2.0%; organic carrier 8.0%-12.0%; wherein the glass powder comprises first main glass powder and second main glass powder, or comprises first main glass powder, second main glass powder, and auxiliary glass powder; the first main glass powder is glass powder in a Pb-Si-B-Li-O system, the second main glass powder is glass powder in a Pb-Bi-B-Li-O system, and the auxiliary glass powder is glass powder in a Ba-B-Si-Li-O system. The conductive silver aluminum paste of the present invention has the advantages of strong anti-aging ability, excellent contact, and high photoelectric conversion efficiency. The present invention further discloses a method for preparing a high-performance conductive silver aluminum slurry, an electrode, and an N-type TOPcon battery.

## Description

### TECHNICAL FIELD

The present invention belongs to the field of silicon solar cells, and in particular, relates to a high-performance conductive silver aluminum paste, a preparation method, an electrode, and an N-type Topcon battery.

### BACKGROUND

Solar energy is clean energy source with the largest reserve and the widest distribution in the current world, and is a hot topic that countries are currently competing to develop. Silicon solar cells are one of the important means of converting solar energy into usable electrical energy, and therefore have also been widely used. A silicon solar cells is mainly composed of a front electrode, an antireflection layer, a PN junction, a silicon substrate, and a back field. When light shines on a surface of the solar cell, it is fully absorbed by a surface antireflection layer, and photons enter a PN junction; the photons are absorbed by the PN junction and generate photoelectric effect inside the PN junction, thereby releasing electrons. The electrons are exported from the surface electrode to form a current, thereby converting light energy into electrical energy.

Electrodes of silicon solar cells are generally printed on surfaces of batteries by conductive paste through screen printing, and then sintered to form conductive silver grid lines. Among them, conductive paste for front surfaces of the current mainstream Se-perc batteries is mainly silver paste, while conductive paste for front surfaces of the new type of N-type TOPcon batteries is mainly silver aluminum paste. Since the development of the new N-type TOPcon batteries is still in an early developing stage at present, the development of silver aluminum paste for the new N-type TOPcon batteries is not yet mature.

Conductive silver aluminum paste generally includes silver powder, aluminum powder, glass powder, organic carrier, etc. Silver powder and aluminum powder mainly play a role in conducting electricity and forming contact; organic carriers are solutions of polymers (such as resins, cellulose, etc.) dissolved in organic solvents, serving as carriers for conductive phases and bonding phases, and playing a role of dispersing the conductive phases and the bonding phases and mixing the conductive phases and the bonding phases together to facilitate screen printing; glass powder mainly plays a role in corroding antireflection films, promoting the conductive phases to form contact, and aiding in sintering and bonding of the conductive phases and substrates.

Since packaging materials of solar cells include certain organic substances, such as EVA, these substances can produce acidic substances, such as acetic acid, under long-term illumination. These substances can corrode surface electrodes of silicon solar cells and lead to issues such as electrode detachment, poor contact, and so on, which reduce photoelectric conversion efficiency of silicon solar cells and seriously affect the service life of silicon solar cells. Therefore, conductive silver aluminum paste with excellent performance must have the characteristics of excellent contact with battery substrates, minimal damage to battery PN junctions, and difficulty in aging and detachment. Excellent contact with battery substrates and minimal damage to battery PN junction make batteries have excellent photoelectric conversion efficiency, and difficulty in aging and detachment can extend batteries' service life. From the perspective of industry development, developing a silver aluminum paste with good aging resistance and excellent electrical performance is also urgently needed at present.

### SUMMARY OF THE DISCLOSURE

The purpose of the present invention is to provide a high-performance conductive silver aluminum paste, a preparation method, an electrode; and an N-type TOPcon battery, which realize a conductive silver aluminum paste with strong anti-aging ability, excellent contact and high photoelectric conversion efficiency. In order to achieve the above purposes, the present invention adopts technical solutions as follows.

A high-performance conductive silver aluminum paste, wherein the conductive silver aluminum paste comprises silver powder, aluminum powder, glass powder, silver aluminum paste additive, and organic carrier; when defining the total weight of the conductive silver aluminum paste as 100%, the weight percentage contents of the components are: silver powder 80.0%-88.0%, aluminum powder 0.5%-2.0%; glass powder 2.5%-6.0%; silver aluminum paste additive 0.1%-2.0%; organic carrier 8.0%-12.0%; wherein the glass powder comprises first main glass powder and second main glass powder, or comprises first main glass powder, second main glass powder, and auxiliary glass powder; the first main glass powder is glass powder in a Pb-Si-B-Li-O system, the second main glass powder is glass powder in a Pb-Bi-B-Li-O system, and the auxiliary glass powder is glass powder in a Ba-B-Si-Li-O system.

Furthermore, when defining the total weight of components contained in the glass powder as 100%, the weight percentage contents of the components are: the first main glass powder and the second main glass powder 60%~100.0%; the auxiliary glass powder 0.0%~40.0%.

Furthermore, in the first main glass powder, when defining the total number of moles of the components contained in the first main glass powder as 100%, the mole percentages of the components are: PbO 30.0%~70.0%; SiO₂ 10.0%~35.0%; B₂O₃ 5.0%-15.0%; Li₂O 2.0%~12.0%; first modified additive 0.0%~30.0%; wherein the first modified additive is an oxide containing one or more element of Zn, Ca, Ba, Bi, Na, K, Te, Se, Ge, Al, and Ga, or a substance that decomposes to obtain the oxide of the element during a process of manufacturing the first main glass powder.

Furthermore, in the second main glass powder, when defining the total number of moles of the components contained in the second main glass powder as 100%, the mole percentages of the components are: PbO 5.0%~50.0%; Bi₂O₃ 5.0%~50.0%; B₂O₃ 5.0%~25.0%; Li₂O 3.0%~20.0%; second modified additive 0.0%~30.0%; wherein the second modified additive is an oxide containing one or more element of Zn, Ca, Ba, Na, K, Al, Si, Ge, Se, Te, Sn, and Ga, or a substance that decomposes to obtain the oxide of the element during a process of manufacturing the second main glass powder.

Furthermore, in the auxiliary glass powder, when defining the total number of moles of the components contained in the auxiliary glass powder as 100%, the mole percentages of the components are: BaO 20.0%~40.0%; B₂O₃ 5.0%~30.0%; SiO₂ 20.0%~50.0%; Li₂O 12.0%~30.0%; auxiliary modified additive 0.0%~20.0%; wherein the auxiliary modified additive is an oxide containing one or more element of Pb, Bi, Al, Ga, K, Na, and Tl, or a substance that decomposes to obtain the oxide of the element during a process of manufacturing the auxiliary glass powder.

Furthermore, the silver aluminum paste additive is at least one of boron element containing silver aluminum paste additive and zinc element containing silver aluminum paste additive; the boron element containing silver aluminum paste additive is one or more of boron nitride, boron carbide, boron powder, aluminum boroide, silicon boroide, tungsten boroide, and molybdenum boroide; the zinc element containing silver aluminum paste additive is one or more of zinc powder, zinc oxide, zinc titanate, zinc stearate, and zinc palmitate.

Furthermore, the maximum particle sizes of the silver powder, the aluminum powder, the glass powder, and the silver aluminum paste additive powder are not more than 8µm.

Furthermore, the organic carrier comprises organic solvent, organic resin, and additive; when defining the total weight of the organic carrier as 100%, the contents of the components are: organic solvent 60.0%~80.0%; organic resin 5.0%~20.0%; additive 1.0%~25.0%.

The present invention further provides a method for preparing the aforesaid high-performance conductive silver aluminum paste, comprising the following steps.

Preparing first main glass powder, second main glass powder, and auxiliary glass powder: weighing raw materials used in first main glass powder according to a preset ratio; mixing them; after melting them at a high temperature, cooling them down, and drying them, through a crushing process, obtaining required first main glass powder; weighing raw materials used in second main glass powder according to a preset ratio; mixing them; after melting them at a high temperature, cooling them down, and drying them, through a crushing process, obtaining required second main glass powder; weighing raw materials used in auxiliary glass powder according to a preset ratio; mixing them; after melting them at a high temperature, cooling them down, and drying them, through a crushing process, obtaining required auxiliary glass powder.

Preparing organic carrier: weighing raw materials used in organic carrier according to a preset ratio; heating, stirring, and mixing them; dispersing them uniformly through high-speed centrifugation, and then filtering them to obtain organic carrier.

Preparing conductive silver aluminum paste: adding silver powder, aluminum powder, the glass powder, and silver aluminum paste additive into prepared organic carrier respectively according to a mass ratio, mixing them and stirring them uniformly, and then grinding them, adjusting their viscosity, and filtering them to obtain conductive silver aluminum paste.

The present invention further provides an electrode, the electrode is formed by sintering the aforesaid high-performance conductive silver aluminum paste on a surface of a battery silicon wafer.

The present invention further provides a Topcon battery comprising the aforesaid electrode.

Advantageous effects of the present invention are as follows.

Firstly, the conductive silver aluminum paste of the present invention adopts glass powder in different systems, which is composed of glass powder in three systems: the first main glass powder, the second main glass powder, and the auxiliary glass powder. The first main glass powder and the second main glass powder are essential components, and the auxiliary glass powder is an auxiliary component. The auxiliary glass powder can be selectively added.

The first main glass powder is glass powder in a Pb-Si-B-Li-O system, which uses a large amount of Si and Pb elements and a lower amount of Li element. A large amount of Si element is used as glass structure body to reduce the content proportion of hydrolyzable element B in the glass structure body, the degree of hydrolysis of the glass structure body in acid and alkali environments can be effectively reduced, and the anti-hydrolysis stability of the silver aluminum paste is improved. The use of lower amount of alkali metal Li further reduces the degree of hydrolysis of glass in acidic and alkaline environments, and improves the anti-hydrolysis stability of the silver aluminum paste. The use of a large amount of Pb element can effectively reduce the softening point of the first main glass powder and the viscosity of the glass liquid, such that the glass liquid still have excellent corrosiveness under low alkali conditions. This not only can effectively etch insulation layers and antireflection films on batteries' surfaces, but also can effectively aid in sintering of silver powder and aluminum powder.

The second main glass powder is glass powder in a Pb-Bi-B-Li-O system, which is a kind of high bismuth glass with a higher softening point than the first main glass powder. At the same time, the high bismuth glass can effectively inhibit glass hydrolysis, and the B-O-Bi structure can effectively dissolve aluminum oxide. This not only further reduces the hydrolysis degree of the silver aluminum paste in acidic and alkaline environments, but also can effectively remove aluminum oxide on the surface of aluminum powder, thereby promoting formation of Ag-Al-Si alloy and reducing contact resistance.

The auxiliary glass powder is glass powder in a Ba-B-Si-Li-O system. Due to the strong alkalinity of Ba element oxides and the appropriate addition of B and Li, the auxiliary glass powder has good aluminum oxide dissolution effect. In use, it can effectively remove aluminum oxide on the surface of aluminum powder, promote the formation of Ag-Al-Si alloy, and improve contact effect.

Therefore, the combination of glass powder in the first main glass powder's, the second main glass powder's, and the auxiliary glass powder's systems not only makes the silver aluminum paste have excellent contact effect, but also reduces the degree of hydrolysis of the silver aluminum paste, and improves the stability and anti-aging strength of the silver aluminum paste.

Secondly, the silver aluminum paste of the present invention uses specific silver aluminum paste additive, which can quickly promote alloying of aluminum powder and silver powder and the formation of P++ regions in the silver aluminum paste. This can further improve the contact effect of the silver aluminum paste and enhance the photoelectric conversion efficiency of the silver aluminum paste.

Accordingly, the present invention realizes a N-type TOPcon silicon solar cell silver aluminum paste with strong anti-aging ability, excellent contact and high photoelectric conversion efficiency.

### DETAILED DESCRIPTION

The present invention provides a high-performance conductive silver aluminum paste, the conductive silver aluminum paste includes silver powder, aluminum powder, glass powder, silver aluminum paste additive, and organic carrier; when defining the total weight of the conductive silver aluminum paste as 100%, the weight percentage contents of the components are: silver powder 80.0%-88.0%, aluminum powder 0.5%-2.0%; glass powder 2.5%-6.0%; silver aluminum paste additive 0.1%-2.0%; organic carrier 8.0%-12.0%.

Among them, the glass powder is combined glass powder of glass powder in different systems, the combined glass powder includes glass powder in three systems: first main glass powder, second main glass powder, and auxiliary glass powder. The first main glass powder and the second main glass powder are essential combination components, and the auxiliary glass powder is an auxiliary combination component. The auxiliary glass powder can be selectively added. That is, the glass powder can include the first main glass powder and the second main glass powder, or include the first main glass powder, the second main glass powder, and the auxiliary glass powder. The first main glass powder is glass powder in a Pb-Si-B-Li-O system, the second main glass powder is glass powder in a Pb-Bi-B-Li-O system, and the auxiliary glass powder is glass powder in a Ba-B-Si-Li-O system.

Specifically: firstly, the first main glass powder is glass powder in a Pb-Si-B-Li-O system, which uses a large amount of Si and Pb elements and a lower amount of Li element. A large amount of Si element is used as glass structure body to reduce the content proportion of hydrolyzable element B in the glass structure body, the degree of hydrolysis of the glass structure body in acid and alkali environments can be effectively reduced, and the anti-hydrolysis stability of the silver aluminum paste is improved. The use of lower amount of alkali metal Li further reduces the degree of hydrolysis of glass in acidic and alkaline environments, and improves the anti-hydrolysis stability of the silver aluminum paste. The use of a large amount of Pb element can effectively reduce the softening point of the first main glass powder and the viscosity of the glass liquid, such that the glass liquid still have excellent corrosiveness under low alkali conditions. This not only can effectively etch insulation layers and antireflection films on batteries' surfaces, but also can effectively aid in sintering of silver powder and aluminum powder.

The second main glass powder is glass powder in a Pb-Bi-B-Li-O system, which is a kind of high bismuth glass with a higher softening point than the first main glass powder. At the same time, the high bismuth glass can effectively inhibit glass hydrolysis, and the B-O-Bi structure can effectively dissolve aluminum oxide. This not only further reduces the hydrolysis degree of the silver aluminum paste in acidic and alkaline environments, but also can effectively remove aluminum oxide on the surface of aluminum powder, thereby promoting formation of Ag-Al-Si alloy and reducing contact resistance.

The auxiliary glass powder is glass powder in a Ba-B-Si-Li-O system. Due to the strong alkalinity of Ba element oxides and the appropriate addition of B and Li, the auxiliary glass powder has good aluminum oxide dissolution effect. In use, it can effectively remove aluminum oxide on the surface of aluminum powder, promote the formation of Ag-Al-Si alloy, and improve contact effect. Whether to add the auxiliary glass powder or not can be selected based on the combination situation of the first main glass powder and the second main glass powder, which can play a balanced role.

Therefore, the combination of glass powder in the first main glass powder's, the second main glass powder's, and the auxiliary glass powder's systems not only makes the silver aluminum paste have excellent contact effect, but also reduces the degree of hydrolysis of the silver aluminum paste, and improves the stability and anti-aging strength of the silver aluminum paste.

Secondly, by adding specific silver aluminum paste additive, it is possible to quickly promote alloying of aluminum powder and silver powder and the formation of P++ regions in the silver aluminum paste. This can further improve the contact effect of the silver aluminum paste and enhance the photoelectric conversion efficiency of the silver aluminum paste.

Furthermore, when defining the total weight of components contained in the glass powder as 100%, the weight percentage contents of the components are: the first main glass powder and the second main glass powder 60%~100.0%; the auxiliary glass powder 0.0%~40.0%.

Among them, when the glass powder only contains the first main glass powder and the second main glass powder, the total content of the first main glass powder and the second main glass powder is 100%, and the content of the auxiliary glass powder is 0%; when the glass powder contains the first main glass powder, the second main glass powder, and the auxiliary glass powder, the total content of the first main glass powder and the second main glass powder is greater than or equal to 60%, and the content of the auxiliary glass powder is less than or equal to 40%.

Furthermore, in the first main glass powder, when defining the total number of moles of the components contained in the first main glass powder as 100%, the mole percentages of the components are: PbO 30.0%~70.0%; SiO₂ 10.0%~35.0%; B₂O₃ 5.0%~15.0%; Li₂O 2.0%~12.0%; first modified additive 0.0%~30.0%; wherein the first modified additive is an oxide containing one or more element of Zn, Ca, Ba, Bi, Na, K, Te, Se, Ge, Al, and Ga, or a substance that decomposes to obtain the oxide of the element during a process of manufacturing the first main glass powder, such as a carbonate, a peroxide, or a complex. Of course, PbO, SiO₂, B₂O₃, and Li₂O can also be introduced by peroxides, carbonates, or complexes of corresponding elements.

Furthermore, in the second main glass powder, when defining the total number of moles of the components contained in the second main glass powder as 100%, the mole percentages of the components are: PbO 5.0%~50.0%; Bi₂O₃ 5.0%~50.0%; B₂O₃ 5.0%~25.0%; Li₂O 3.0%~20.0%; second modified additive 0.0%~30.0%; wherein the second modified additive is an oxide containing one or more element of Zn, Ca, Ba, Na, K, Al, Si, Ge, Se, Te, Sn, and Ga, or a substance that decomposes to obtain the oxide of the element during a process of manufacturing the second main glass powder, such as a carbonate, a peroxide, or a complex. Of course, PbO, Bi₂O₃, B₂O₃, and Li₂O can also be introduced by peroxides, carbonates, or complexes of corresponding elements.

Furthermore, in the auxiliary glass powder, when defining the total number of moles of the components contained in the auxiliary glass powder as 100%, the mole percentages of the components are: BaO 20.0%~40.0%; B₂O₃ 5.0%~30.0%; SiO₂ 20.0%~50.0%; Li₂O 12.0%~30.0%; auxiliary modified additive 0.0%~20.0%; wherein the auxiliary modified additive is an oxide containing one or more element of Pb, Bi, Al, Ga, K, Na, and Tl, or a substance that decomposes to obtain the oxide of the element during a process of manufacturing the auxiliary glass powder, such as a carbonate, a peroxide, or a complex. Of course, BaO, B₂O₃, SiO₂, and Li₂O can also be introduced by peroxides, carbonates, or complexes of corresponding elements.

Furthermore, the silver aluminum paste additive is at least one of boron element containing silver aluminum paste additive and zinc element containing silver aluminum paste additive; the boron element containing silver aluminum paste additive is one or more of boron nitride, boron carbide, boron powder, aluminum boroide, silicon boroide, tungsten boroide, and molybdenum boroide; the zinc element containing silver aluminum paste additive is one or more of zinc powder, zinc oxide, zinc titanate, zinc stearate, and zinc palmitate. In the present invention, by adding the boron element containing silver aluminum paste additive and/or the zinc element containing silver aluminum paste additive, wherein the silver aluminum paste additive is in a powder form, it is possible to quickly promote alloying of aluminum powder and silver powder and the formation of P++ regions in the silver aluminum paste. This can further improve the contact effect of the silver aluminum paste and enhance the photoelectric conversion efficiency of the silver aluminum paste.

Furthermore, the silver powder, the aluminum powder, the glass powder, and the silver aluminum paste additive powder can be selected as spherical powder or quasi-spherical powder, and the maximum particle sizes of the silver powder, the aluminum powder, the glass powder, and the silver aluminum paste additive powder are not more than 8µm.

Furthermore, the organic carrier includes organic solvent, organic resin, and additive; when defining the total weight of the organic carrier as 100%, the contents of the components are: organic solvent 60.0%~80.0%; organic resin 5.0%~20.0%; additive 1.0%~25.0%.

Among them, the organic solvent is one or more of diethylene glycol butyl ether acetate, diethylene glycol ether acetate, alcohol ester twelve, dimethyl phthalate, ethylene glycol butyl ether phthalate, tripropylene glycol monomethyl ether, diethylene glycol butyl ether, and pentaerythritol triacrylate; the organic resin is one or more of SEPS resin, SEBS resin, polyvinyl butyral resin, poly α-methyl styrene resin, petroleum resin, acrylic resin, cellulose acetate butyrate, carboxymethyl cellulose, and hydroxyethyl cellulose; and the additive is one or more of silicone oil, palmitic acid, lithium stearate, polyamide wax, and hydrogenated castor oil.

The present invention further provides a method for preparing the high-performance conductive silver aluminum paste, comprising the following steps.

Preparing the first main glass powder, the second main glass powder, and the auxiliary glass powder: weighing the raw materials of the first main glass powder according to a set ratio, then mixing them evenly through ball milling or sieving, and placing them in a crucible; placing the crucible in a high-temperature furnace and melting them at 800 °C~1200 °C for 10min~60min; after melting evenly, pouring glass liquid into cold water to perform rapid cooling treatment and obtain glass particles; after performing drying treatment for the glass particles, preliminarily crushing them, and then finely crushing them to obtain the required first main glass powder with a suitable particle size; according to the above method for preparing the first main glass powder, weighing the raw materials used for the second main glass powder according to a set ratio, mixing them, after melting them at high temperature, cooling them, and drying them, then crushing them to obtain the required second main glass powder; according to the above method for preparing the first main glass powder, weighing the raw materials used for the auxiliary glass powder according to a set ratio, mixing them, after melting them at high temperature, cooling them, and drying them, then crushing them to obtain the required auxiliary main glass powder.

Preparing the organic carrier: weighing the raw materials of the organic solvent, the organic resin, and the silver aluminum paste additive used for the organic carrier according to a set ratio, then heating them in a water bath at 70 °C∼100 °C, stirring them, and mixing them evenly; after dispersing them uniformly through high-speed centrifugation, filtering them to obtain the required organic carrier.

Preparing the conductive silver aluminum paste: adding the prepared silver powder, aluminum powder, glass powder, silver aluminum paste additive, and organic carrier into the prepared organic carrier respectively according to a mass ratio, mixing them and stirring them evenly, then milling them with three rollers, adjusting their viscosity, and finally filtering them to obtain the required conductive silver aluminum paste; among them, the glass powder includes the prepared first main glass powder and second main glass powder, or includes the prepared first main glass powder, second main glass powder, and auxiliary glass powder.

The present invention further provides an electrode, the electrode is formed by sintering the aforesaid conductive silver aluminum paste on a surface of a battery silicon wafer. The prepared conductive silver aluminum paste is printed by a way of screen printing to form gate lines required by the front of an N-type TOPcon battery, and then sintered to form a conductive silver gate electrode. Other technical features of this electrode can refer to the existing technology and will not be elaborated here.

The present invention further provides a battery including the above electrode. Other technical features of this battery can refer to the existing technology and will not be elaborated here.

The following further describes the present invention in detail in conjunction with experimental examples and specific implementations. However, it should not be considered that the scope of the above subject matter of the present invention is limited to the following embodiments, and any technology implemented based on the content of the present invention belongs to the scope of the present invention.

The following will be explained in conjunction with specific embodiments.

### Embodiments G101~G106

Preparation of the first main glass powder: calculating and weighing the raw materials used for the first main glass powder respectively according to a set formula, then mixing them evenly through ball milling or sieving, and placing them in a crucible; placing the crucible in a high-temperature furnace and melting them at 800 °C~1200 °C for 10min~60min; after melting evenly, pouring glass liquid into cold water to perform rapid cooling treatment and obtain glass particles; after performing drying treatment for the glass particles, preliminarily crushing them, and then finely crushing them to obtain the required first main glass powder with a suitable particle size. Among them, the first main glass powder is numbered as G101 to G106, and its specific molar composition is shown in Table 1.

**Table 1 Table of Mole Percentages of First Main Glass Powder (mol%)**

| Number | G101 | G102 | G103 | G104 | G105 | G106 |
|---|---|---|---|---|---|---|
| PbO | 56.0 | 60.0 | 70.0 | 30.0 | 52.5 | 44.5 |
| SiO₂ | 10.0 | 24.0 | 10.0 | 35.0 | 17.5 | 15.0 |
| B₂O₃ | 13.5 | 5.0 | 15.0 | 5.0 | 9.0 | 7.5 |
| Li₂CO₃ | 6.0 | 2.0 | 5.0 | 12.0 | 4.5 | 3.0 |
| ZnO | 9.0 | 4.5 | | 2.0 | 9.0 | 15.0 |
| CaCO₃ | | | | | 1.5 | |
| BaCO₃ | | 3.0 | | | | |
| Bi₂O₃ | 1.0 | | | 12.0 | 2.0 | |
| Na₂CO₃ | | | | | 0.5 | |
| K₂CO₃ | | | | | 0.5 | 1.5 |
| TeO₂ | | | | 1.0 | | |
| SeO₂ | 4.0 | | | 2.0 | 3.0 | 6.0 |
| GeO₂ | | | | 1.0 | | 4.5 |
| Al₂O₃ | 0.5 | | | | | |
| Ga₂O₃ | | 1.5 | | | | 3.0 |
| Total | 100.0 | 100.0 | 100.0 | 100.0 | 100.0 | 100.0 |

### Embodiments G201~G206

Preparation of the second main glass powder: calculating and weighing the raw materials used for the second main glass powder respectively according to a set formula, then mixing them evenly through ball milling or sieving, and placing them in a crucible; placing the crucible in a high-temperature furnace and melting them at 800 °C~1200 °C for 10min~60min; after melting evenly, pouring glass liquid into cold water to perform rapid cooling treatment and obtain glass particles; after performing drying treatment for the glass particles, preliminarily crushing them, and then finely crushing them to obtain the required second main glass powder with a suitable particle size. The second main glass powder is numbered as G201 to G206, and its specific molar composition is shown in Table 2.

**Table 2 Table of Mole Percentages of Second Main Glass Powder (mol%)**

| Number | G201 | G202 | G203 | G204 | G205 | G206 |
|---|---|---|---|---|---|---|
| PbO | 35.0 | 5.0 | 50.0 | 40.0 | 30.0 | 35.0 |
| Bi₂O₃ | 18.0 | 50.0 | 5.0 | 10.0 | 15.0 | 35.0 |
| B₂O₃ | 19.5 | 25.0 | 12.0 | 15.0 | 5.0 | 21.0 |
| Li₂CO₃ | 10.5 | 9.0 | 3.0 | 7.5 | 20.0 | 9.0 |
| ZnO | 7.0 | 3.0 | 15.0 | 6.0 | | |
| CaCO₃ | | 2.0 | | 4.0 | | |
| BaCO₃ | | | 1.5 | | 3.0 | |
| Na₂CO₃ | | | | 1.0 | | |
| K₂CO₃ | | | 1.5 | | | |
| Al₂O₃ | | | | 0.5 | 1.0 | |
| SiO₂ | 10.0 | 6.0 | 10.5 | 9.0 | 22.0 | |
| GeO₂ | | | | 4.0 | | |
| SeO₂ | | | | | 3.0 | |
| TeO₂ | | | | 3.0 | | |
| SnO₂ | | | | | 1.0 | |
| Ga₂O₃ | | | 1.5 | | | |
| Total | 100.0 | 100.0 | 100.0 | 100.0 | 100.0 | 100.0 |

### Embodiments G301~G306

Preparation of the auxiliary glass powder: calculating and weighing the raw materials used for the auxiliary glass powder respectively according to a set formula, then mixing them evenly through ball milling or sieving, and placing them in a crucible; placing the crucible in a high-temperature furnace and melting them at 800 °C∼1200 °C for 10min~60min; after melting evenly, pouring glass liquid into cold water to perform rapid cooling treatment and obtain glass particles; after performing drying treatment for the glass particles, preliminarily crushing them, and then finely crushing them to obtain the required auxiliary glass powder with a suitable particle size. The auxiliary glass powder is numbered as G301 to G306, and its specific molar composition is shown in Table 3.

**Table 3 Table of Mole Percentages of Auxiliary Glass Powder (mol%)**

| Number | G301 | G302 | G303 | G304 | G305 | G306 |
|---|---|---|---|---|---|---|
| BaCO₃ | 32.0 | 20.0 | 27.5 | 24.0 | 40.0 | 22.5 |
| B₂O₃ | 30.0 | 5.0 | 13.0 | 9.0 | 21.0 | 21.0 |
| SiO₂ | 20.0 | 50.0 | 27.5 | 30.0 | 21.0 | 31.5 |
| Li₂CO₃ | 18.0 | 24.0 | 12.0 | 30.0 | 15.0 | 21.0 |
| PbO | | 1.0 | 10.5 | 4.5 | | 1.0 |
| Bi₂O₃ | | | 3.0 | 1.5 | | 2.0 |
| Al₂O₃ | | | | 0.5 | | |
| Ga₂O₃ | | | 1.5 | | | 0.5 |
| K₂CO₃ | | | 2.0 | | | |
| Na₂CO₃ | | | | | 3.0 | 0.5 |
| Tl₂O₃ | | | 3.0 | 0.5 | | |
| Total | 100.0 | 100.0 | 100.0 | 100.0 | 100.0 | 100.0 |

### Embodiments C101∼C106

Preparation of the organic carrier: weighing the raw materials of the organic solvent, the organic resin, and the additive used for the organic carrier according to a set ratio, then heating them in a water bath at 70 °C~100 °C, stirring them, and mixing them evenly; after dispersing them uniformly through high-speed centrifugation, filtering them to obtain the required organic carrier, which is numbered as C101~C106 and prepared to use. The mass composition ratios of the organic carrier is shown in Table 4.

**Table 4 Table of Weight Components of Organic Carrier (wt%)**

| | Mass Content | | | | | |
|---|---|---|---|---|---|---|
| Organic Carrier Number | C101 | C102 | C103 | C104 | C105 | C106 |
| Organic Solvent | 70.5 | 80.0 | 60.0 | 75.0 | 67.5 | 73.0 |
| Organic Resin | 17.5 | 5.0 | 25.0 | 24.0 | 7.5 | 12.5 |
| Additive | 12.0 | 15.0 | 15.0 | 1.0 | 25.0 | 14.5 |
| Total | 100.0 | 100.0 | 100.0 | 100.0 | 100.0 | 100.0 |

### Embodiments G01~G15

Preparation of the conductive silver aluminum paste: numbering silver powder as Ag1, and numbering aluminum powder as Al1; numbering boron element containing silver aluminum paste additives with appropriate particle sizes, wherein boron nitride, boron carbide, boron powder, aluminum boroide, silicon boroide, tungsten boroide, and molybdenum boroide are sequentially numbered as B01-B07; numbering zinc element containing silver aluminum paste additives with appropriate particle sizes, wherein zinc powder, zinc oxide, zinc titanate, zinc stearate, and zinc palmitate are sequentially numbered as Z01-Z05. According to selected substance combinations and provided mass percentages in Table 5, weighing corresponding silver powder, aluminum powder, glass powder, and silver aluminum paste additive respectively, adding them into organic carriers with corresponding models and masses in sequence, mixing them and stirring them evenly, using a three-roll mill to grind the paste, filtering it to obtain coarse paste, and then mixing it to obtain conductive silver aluminum paste G01-G15. Specific weight compositions of the silver aluminum paste are shown in Table 5.

**Table 5 Table of weight compositions of silver aluminum paste (wt%)**

| Composition | Number | G01 | G02 | G03 | G04 | G05 | G06 | G07 |
|---|---|---|---|---|---|---|---|---|
| Silver powder | Ag1 | 84.5 | 80.0 | 86.0 | 85.0 | 88.0 | 83.0 | 85.0 |
| Aluminum powder | Al1 | 1.0 | 2.0 | 1.5 | 0.5 | 1.2 | 0.9 | 0.9 |
| | G101 | | | | | 0.7 | | 1.5 |
| | G102 | 1.8 | | | | | | |
| | G103 | | | 1.5 | | | 0.3 | |
| | G104 | | | | | 0.2 | 1.8 | |
| | G105 | | | | 3.0 | | | |
| | G106 | | 2.8 | | | | | |
| | G201 | 0.9 | | | | | | |
| | G202 | | | | 1.0 | | | |
| Glass powder | G203 | | 1.2 | | | | 1.8 | |
| | G204 | | | 0.5 | | | | 1.4 |
| | G205 | | | | 1.2 | | | |
| | G206 | | | | | 1.0 | | |
| | G301 | | | | 0.5 | | | |
| | G302 | | | | 0.3 | | | |
| | G303 | | | | | 0.3 | | |
| | G304 | 1.2 | | | | | | |
| | G305 | | | | | | | 0.6 |
| | G306 | | | | | | 0.3 | |
| Silver aluminum paste additive | B01 | | | | | 0.1 | | 0.3 |
| | B02 | | | | | 0.1 | | |
| | B03 | | 0.5 | | | | | |
| | B04 | 0.3 | | | | | | |
| | B05 | | | 0.1 | | | 0.6 | |
| | B06 | | | | 0.2 | | | |
| | B07 | | | | | 0.1 | | |
| | Z01 | | 0.5 | | | | | |
| | Z02 | 0.5 | | | | | | 0.6 |
| | Z03 | | | | 0.3 | | 0.1 | |
| | Z04 | | 1.0 | | | | | |
| | Z05 | | | | | 0.3 | | 0.4 |
| Organic carrier | C101 | 9.8 | | | | | | |
| | C102 | | 12.0 | | | | | |
| | C103 | | | | | | 11.2 | |
| | C104 | | | | 8.0 | | | |
| | C105 | | | | | 8.0 | | 9.3 |
| | C106 | | | 10.4 | | | | |
| Total | | 100.0 | 100.0 | 100.0 | 100.0 | 100.0 | 100.0 | 100.0 |

Continued Table 5 Table of weight compositions of silver aluminum paste (wt%)

| Composition | Number | G08 | G09 | G10 | G11 | G12 | G13 | G14 | G15 |
|---|---|---|---|---|---|---|---|---|---|
| Silver powder | Ag1 | 86.1 | 82.5 | 87.1 | 83.7 | 84.3 | 82.7 | 83.6 | 81.2 |
| Aluminum powder | Al1 | 1.3 | 1.8 | 0.6 | 1.6 | 1.1 | 1.0 | 1.5 | 1.8 |
| | G101 | | | | 1.3 | | | | |
| | G102 | 2.4 | | | | | | | 0.5 |
| | G103 | | | 0.9 | | | | 1.0 | |
| | G104 | | | | 0.9 | 2.1 | | | 1.2 |
| | G105 | | 4.3 | | | | 1.7 | | |
| | G106 | | | 0.9 | | | | | 0.6 |
| | G201 | 0.6 | | | 0.6 | | | | |
| Glass powder | G202 | | | 0.7 | | | | | 0.7 |
| | G203 | | | 0.2 | | | | | |
| | G204 | | | | | 0.9 | | | 1.2 |
| | G205 | | 0.9 | | | | 0.3 | 1.0 | |
| | G206 | | | 0.5 | | | 1.2 | | |
| | G301 | | | | | | | | |
| | G302 | | | | | 0.6 | | | |
| | G303 | | | | | | 0.8 | | |
| | G304 | | | | 0.7 | | | | |
| | G305 | | | | | | | | |
| | G306 | | | | | | | | 0.9 |
| | B01 | 0.5 | | | | | | | |
| | B02 | | | | | | | | |
| | B03 | | 0.3 | | | | | 0.4 | |
| | B04 | | | 0.3 | | 0.6 | | | 0.3 |
| | B05 | | | | | | 0.3 | | |
| Silver aluminum paste additive | B06 | | | | 0.3 | | | | |
| | B07 | | | | | | | | 0.2 |
| | Z01 | | | | | | | | 0.3 |
| | Z02 | | | | | | 0.2 | | |
| | Z03 | | 0.3 | | | | 0.3 | 0.2 | 0.3 |
| | Z04 | | | 0.6 | | 0.2 | | | |
| | Z05 | | | | 0.3 | | | 0.3 | |
| Organic carrier | C101 | | | 8.2 | | | | | |
| | C102 | | | | | | | | 10.8 |
| | C103 | | | | 10.6 | | | 12.0 | |
| | C104 | 9.1 | | | | | 11.5 | | |
| | C105 | | | | | 10.2 | | | |
| | C106 | | 9.9 | | | | | | |
| Total | | 100.0 | 100.0 | 100.0 | 100.0 | 100.0 | 100.0 | 100.0 | 100.0 |

### Test Examples

The silver aluminum paste prepared in the above embodiments G01-G15 is screen-printed onto battery surfaces on N-type TOPcon battery cells, and then dried, sintered, and cooled to obtain batteries containing printed silver gate electrodes. Photoelectric conversion efficiency test is performed for the obtained battery. Furthermore, the prepared silicon solar cells are exposed to a sealed environment in a 3% potassium chloride acetate saturated solution, and at 85 °C, the air in the sealed environment is circulated for 10 hours by fan drive; then the fan is turned off to cool the temperature in the sealed environment to a room temperature; the silicon solar cells are taken out, and the photoelectric conversion efficiency of the cells after the experiment is tested. Efficiency differences between the previous and subsequent cells are compared and the attenuation percentages of the photoelectric efficiency of these cells are calculated out. In order to facilitate the observation of the electrical performance characteristics of the silver aluminum paste of the present invention, silver aluminum paste 995PFB-V80 and 995PFB-V90 produced by Shanghai Silver Paste Science and Technology Co., Ltd. are selected for printing, sintering, and testing their electrical performances under the same conditions to compare with the silver aluminum paste of the present invention. The test results are shown in Table 6.

**Table 6 Table of Test Data of Silver Aluminum Paste**

| | Silver aluminum paste number | Open circuit voltage (V) | Series resistance (mΩ) | Covnersion efficiency (%) | Attenuation rate of acetic acid experiment (%) |
|---|---|---|---|---|---|
| Comparison examples | 995PFB-V80 | 0.7195 | 1.247 | 25.16 | 37.28 |
| | 995PFB-V90 | 0.7184 | 1.136 | 25.03 | 12.35 |
| | G01 | 0.7206 | 1.178 | 25.21 | 12.31 |
| | G02 | 0.7203 | 1.105 | 25.26 | 9.37 |
| | G03 | 0.7201 | 1.124 | 25.23 | 13.75 |
| | G04 | 0.7202 | 1.147 | 25.21 | 10.28 |
| | G05 | 0.7205 | 1.165 | 25.22 | 13.24 |
| | G06 | 0.7203 | 1.166 | 25.20 | 10.16 |
| | G07 | 0.7206 | 1.123 | 25.29 | 12.13 |
| Embodiments | G08 | 0.7204 | 1.139 | 25.24 | 11.07 |
| | G09 | 0.7201 | 1.191 | 25.19 | 6.08 |
| | G10 | 0.7206 | 1.158 | 25.23 | 9.21 |
| | G11 | 0.7202 | 1.160 | 25.21 | 10.38 |
| | G12 | 0.7207 | 1.212 | 25.24 | 12.37 |
| | G13 | 0.7207 | 1.173 | 25.28 | 12.05 |
| | G14 | 0.7209 | 1.197 | 25.22 | 7.86 |
| | G15 | 0.7205 | 1.124 | 25.27 | 11.27 |

From Table 6, it can be known that: by comparing the embodiments G01-G15 of the present invention with the silver aluminum paste 995PFB-V80 and 996PFB-V90 produced by Shanghai Silver Paste Science and Technology Co., Ltd., it is found that the photoelectric conversion efficiency of 995PFB-V80 is good, but its attenuation in acetic acid test is large and its aging resistance is poor; the photoelectric conversion efficiency of 996PFB-V90 is poor, but its attenuation in acetic acid test is small and its aging resistance is good. When the two are compared with the silver aluminum paste G01-G15 of the present invention, the silver aluminum paste batteries of the present invention have high open circuit voltages, excellent contact resistances, high photoelectric conversion efficiency, and low attenuation rates in acetic acid test, which indicates that the silver aluminum paste provided by the presen invention has high photoelectric conversion efficiency, low attenuation rate in acetic acid test, and strong anti-aging ability.

It should be noted that each embodiment in this specification is described in a progressive manner, and each embodiment focuses on differences from other embodiments. The same and similar parts between the embodiments can be referred to each other.

The above description is only a specific implementation of the present invention, but the protection scope of the present invention is not limited to this. Any changes or replacements that can easily be imagined by technicians familiar with the technical field within the technical scope disclosed by the present invention should be covered within the protection scope of the present invention. Therefore, the protection scope of the present invention should be based on the attached claims.

## Claims

1. A high-performance conductive silver aluminum paste, wherein the conductive silver aluminum paste comprises silver powder, aluminum powder, glass powder, silver aluminum paste additive, and organic carrier; when defining the total weight of the conductive silver aluminum paste as 100%, the weight percentage contents of the components are: silver powder 80.0%-88.0%, aluminum powder 0.5%-2.0%; glass powder 2.5%-6.0%; silver aluminum paste additive 0.1%-2.0%; organic carrier 8.0%-12.0%;
wherein the glass powder comprises first main glass powder and second main glass powder, or comprises first main glass powder, second main glass powder, and auxiliary glass powder; the first main glass powder is glass powder in a Pb-Si-B-Li-O system, the second main glass powder is glass powder in a Pb-Bi-B-Li-O system, and the auxiliary glass powder is glass powder in a Ba-B-Si-Li-O system;
when defining the total weight of components contained in the glass powder as 100%, the weight percentage contents of the components are: the first main glass powder and the second main glass powder 60%~100.0%; the auxiliary glass powder 0.0%~40.0%;
in the second main glass powder, when defining the total number of moles of the components contained in the second main glass powder as 100%, the mole percentages of the components are: PbO 5.0%~50.0%; Bi₂O₃ 5.0%~50.0%; B₂O₃ 5.0%~25.0%; Li₂O 3.0%~20.0%; second modified additive 0.0%∼30.0%;
wherein the second modified additive is an oxide containing one or more element of Zn, Ca, Ba, Na, K, Al, Si, Ge, Se, Te, Sn, and Ga, or a substance that decomposes to obtain the oxide of the element during a process of manufacturing the second main glass powder.

2. The high-performance conductive silver aluminum paste according to claim 1, wherein in the first main glass powder, when defining the total number of moles of the components contained in the first main glass powder as 100%, the mole percentages of the components are: PbO 30.0%~70.0%; SiO₂ 10.0%~35.0%; B₂O₃ 5.0%~15.0%; Li₂O 2.0%~12.0%; first modified additive 0.0%~30.0%;
wherein the first modified additive is an oxide containing one or more element of Zn, Ca, Ba, Bi, Na, K, Te, Se, Ge, Al, and Ga, or a substance that decomposes to obtain the oxide of the element during a process of manufacturing the first main glass powder.

3. The high-performance conductive silver aluminum paste according to claim 1, wherein in the auxiliary glass powder, when defining the total number of moles of the components contained in the auxiliary glass powder as 100%, the mole percentages of the components are: BaO 20.0%~40.0%; B₂O₃ 5.0%~30.0%; SiO₂ 20.0%~50.0%; Li₂O 12.0%~30.0%; auxiliary modified additive 0.0%~20.0%;
wherein the auxiliary modified additive is an oxide containing one or more element of Pb, Bi, Al, Ga, K, Na, and Tl, or a substance that decomposes to obtain the oxide of the element during a process of manufacturing the auxiliary glass powder.

4. The high-performance conductive silver aluminum paste according to claim 1, wherein the silver aluminum paste additive is at least one of boron element containing silver aluminum paste additive and zinc element containing silver aluminum paste additive; the boron element containing silver aluminum paste additive is one or more of boron nitride, boron carbide, boron powder, aluminum boroide, silicon boroide, tungsten boroide, and molybdenum boroide; the zinc element containing silver aluminum paste additive is one or more of zinc powder, zinc oxide, zinc titanate, zinc stearate, and zinc palmitate.

5. The high-performance conductive silver aluminum paste according to claim 1, wherein the maximum particle sizes of the silver powder, the aluminum powder, the glass powder, and the silver aluminum paste additive powder are not more than 8µm.

6. The high-performance conductive silver aluminum paste according to claim 1, wherein the organic carrier comprises organic solvent, organic resin, and additive; when defining the total weight of the organic carrier as 100%, the contents of the components are: organic solvent 60.0%~80.0%; organic resin 5.0%~20.0%; additive 1.0%~25.0%.

7. A method for preparing the high-performance conductive silver aluminum paste according to any one of claims 1-6, comprising the following steps:
preparing first main glass powder, second main glass powder, and auxiliary glass powder: weighing raw materials used in first main glass powder according to a preset ratio; mixing them; after melting them at a high temperature, cooling them down, and drying them, through a crushing process, obtaining required first main glass powder; weighing raw materials used in second main glass powder according to a preset ratio; mixing them; after melting them at a high temperature, cooling them down, and drying them, through a crushing process, obtaining required second main glass powder; weighing raw materials used in auxiliary glass powder according to a preset ratio; mixing them; after melting them at a high temperature, cooling them down, and drying them, through a crushing process, obtaining required auxiliary glass powder;
preparing organic carrier: weighing raw materials used in organic carrier according to a preset ratio; heating, stirring, and mixing them; dispersing them uniformly through high-speed centrifugation, and then filtering them to obtain organic carrier;
preparing conductive silver aluminum paste: adding silver powder, aluminum powder, the glass powder, and silver aluminum paste additive into prepared organic carrier respectively according to a mass ratio, mixing them and stirring them uniformly, and then grinding them, adjusting their viscosity, and filtering them to obtain conductive silver aluminum paste.

8. An electrode, wherein the electrode is formed by sintering the high-performance conductive silver aluminum paste according to any one of claim 1-6 on a surface of a battery silicon wafer.

9. A Topcon battery comprising the electrode according to claim 8.
